# EUROPEAN PATENT APPLICATION

(11) **EP 1 961 842 A1**
(43) Date of publication of application: **27.08.2008**
(21) Application number: 07090029.5
(22) Date of filing: 22.02.2007
(51) Int. Cl.: C25D 17/00, C25D 17/02, C25D 17/12, C25D 21/12

(54) **Device and method for the electrolytic plating of a metal**

(71) Applicant: ATOTECH Deutschland GmbH, 10553 Berlin (DE)
(72) Inventor: Matejat, Kai-Jens, 16727 Oberkrämer (DE); Lamprecht, Sven, 16727 Oberkrämer (DE); Bangerter, Timo, 13351 Berlin (DE); Reents, Bert, 10407 Berlin (DE)
(74) Representative: Bressel, Burkhard

(57) **Abstract**

To achieve uniform electroplating of a metal on a work piece a device is provided, which comprises at least one anode and a diaphragm comprising a fill made of packing material. The diaphragm is located in the device such that electric field lines extending between the at least one anode and the work piece placed in the device at least partially traverse the diaphragm.

## Description

### Field of the Invention

The invention relates to a device and method for the electrolytic plating of a metal. Such device and method are particularly suited for electrolytically plating copper on a work piece, such as on a printed circuit board, or for plating copper or another metal onto any other type of work piece, for example on sanitary accessories parts, automotive component parts, furniture fittings, juwelry and engine component parts.

### Background Art

Using electrolytic metal plating, a plurality of metals and metal alloys, for example copper, nickel, cobalt, iron, chromium, zinc, tin, lead, gold, silver, rhodium as well as alloys of these metals among each other and with other elements, like phosphorus and boron, may be deposited onto a work piece. Coatings of these metals and alloys are produced by contacting the work piece with a respective metal plating liquid. Electroplating may be performed in so-called dip-tanks, in which the liquid is contained and in which the work piece is suspended from a carrier and arranged in the tank vis-à-vis an anode, both being in contact with the liquid, as well as in a so-called horizontal conveyorized plating machine. In the latter case, the work pieces, more specifically printed circuit material, are conveyed in a horizontal position and horizontal direction through the machine and current is flowing between this work piece and anodes being arranged vis-a-vis the work piece. In any of these arrangements electroplating current is applied to the work piece by contacting the work piece with the negative pole of a current source whereas the anode is contacted with the positive pole of the current source. The anode is also brought into contact with the plating liquid. In general, electroplating may be effected with direct current as well as with pulse current or reverse pulse current.

Generally, the electroplating liquid is aqueous and contains ions of the metal to be deposited, substances influencing electrolytic conductivity of the solution, like an acid, and additives which impart the metal coating the required properties, such as brightness, tensile strength and hardness. Such additives are usually organic compounds which influence the deposition process. Uniformity of the metal deposit, more specifically thickness uniformity thereof, is likewise of major importance. It has emerged however that thickness of the metal coating may depend on many influencing factors, such as, among others, electric conductivity of the electroplating liquid, the shape of the work piece to be metal plated and on the type of anode used, the pattern of the metal to be formed by plating and the additive content in the electroplating liquid and its composition. Especially, work pieces to be metal plated which have a complex shape or a complex pattern of the metal may not be easily metal plated with sufficient uniformity of metal thickness as a result thereof. Furthermore, if a conventional soluble anode is used, *i.e.,* an anode which is made from the metal to be deposited, such that this anode is consumed during the electroplating process, non-uniform metal coatings may undesirably be produced due to the fact that the anodes upon consumption thereof change their shape such that electric field line distribution between the work piece and the anode and hence local current density distribution at the work piece surface will change permanently. Non-uniformity of coating thickness will inevitably lead to minor quality of the metal deposit, because, apart from unevenness of the appearance thereof, unevenness of the physical properties will likewise result thereof, such as uneven tensile strength, ductility and hardness.

In order to improve metal plating performance, several approaches have been made. Specifically, in order to overcome the problems associated with soluble anode consumption, insoluble anodes have been used, these anodes being consistent in shape since they do not dissolve in the electroplating liquid. Such anodes may be made of an inert metal like titanium.

Further, in order to provide a remedy of adverse effects associated with using insoluble instead of soluble anodes, US 2006/0226002 A1 discloses a method of electroplating, comprising using an insoluble anode and a screen, the insolube anode comprising an anode base body having a non-noble metal outer surface and a metal base body material which is conductive in alkaline solutions and which is selected from the group consisting of steel, stainless steel, nickel, nickel alloy, cobalt and cobalt alloys. The screen may be disposed around the anode providing spacing between the screen and the anode base body. The screen is made from a non-conductive material or from a self-passivating metal. It may be formed as a grid, network or fabric. This document further discloses that the use of the insoluble anode serves to ensure considerably reduced oxidation of the organic additives used in the electroplating liquid.

Further, EP 1 717 351 A1 discloses a method of electrolytic metal plating comprising using an electroplating device comprising an anode which is multiphase and which is, more particularly, made of a carrier and a screen spaced from the carrier, wherein the carrier is made of stainless steel or titanium having an active coat thereon, which may preferably be made of iridium oxide or of platinum. The screen may be made of a metal, plastics or glass web. The electroplating liquid contains chloride ions in excess of 70 mg/l and an element selected from the group consisting of molybdenum, vanadium, zirconium, tantalum, tungsten, hafnium and titanium in a range of from 5 to 5,000 mg/l. This document, too, relates to the problem of decomposition of additives. Moreover, this document mentions that the device would ensure more uniform thickness distribution of the metal coating.

Furthermore, US 5,425,862 A discloses an apparatus for the electroplating of a thin plastic film, which is provided on one or both sides with a conductive coating, this apparatus comprising at least one chamber which can be charged with electroplating liquid. The film is electrically contacted outside the chamber. The anodes used in the chambers are considered expediently inert dimensionally stable anodes. The apparatus uses very soft, open-pored plastic foam to stabilize the plastic film while it is conveyed through a horizontal conveyorized electroplating device. The foam permits the passage of the electroplating liquid.

The known methods and devices do not provide sufficiently uniform metal coatings. Furthermore, it has emerged that alloy, plating is not sufficiency consistent, especially on complex parts.

Accordingly it is an object of the present invention to provide means for plating a work piece with a metal coating having uniform thickness all over the work piece surface.

It is still another object of the present invention to provide means for plating a work piece with a metal alloy coating having consistent alloy composition being substantially constant all over the surface of the work piece.

It is still another object of the present invention to provide means for plating a work piece with a metal comprising ensuring that additives contained in the electroplating liquid used are not consumed excessively.

Further, it is still another object of the present invention to provide a device for the electrolytic plating of a metal on a work piece.

Further, it is still another object of the present invention to provide a method of electrolytic plating of a metal on a work piece.

### Summary of the Invention

The present invention provides a device for the electrolytic plating of a metal on a work piece, the device comprising at least one anode and a diaphragm, wherein the diaphragm comprises a fill made of packing material and is located in the device such that electric field lines extending between the at least one anode and the work piece placed in the device at least partially traverse the diaphragm.

The present invention also provides a method of electrolytic plating of a metal on a work piece, comprising providing at least one anode and the work piece, bringing the at least one anode and the work piece into contact with an electroplating liquid, providing a diaphragm and locating same with respect to the at least one anode and the work piece, such that electric field lines extending between the at least one anode and the work piece at least partially traverse the diaphragm, and flowing an electric current between the at least one anode and the work piece, wherein the diaphragm comprises a fill made of packing material.

The diaphragm preferably comprises a casing with the fill of packing material being contained in said casing. Alternatively the fill may be made by bonding the individual pieces of the fill together while leaving interstices between them to form a body of cohesive pieces. The interstices will predominantly be connected in order to be able to be filled with electroplating liquid.

The use of the diaphragm comprising the fill made of packing material renders deposition of metal on the surface of the work piece very uniform. Especially thickness distribution across the surface of the work piece is made very uniform. Likewise composition of a metal alloy deposited on the work piece is very uniform across the surface thereof such that there is no substantial deviation from a mean alloy composition across the work piece surface.

Though not fully understood and by not limiting the scope of this invention by any explanation of the effects found out, it is assumed that the diaphragm increases electric resistance across the path between the work piece and the anode and cross-sectional area which may be traversed by electric filed lines. Such increase would accordingly equalize local electric potential at the surface of the work piece thus likewise equalizing cathodic current density. Hence, both, thickness variation of the metal coating and variation of the composition of an alloy being deposited to the work piece surface across the surface thereof, are minimized such that excellent uniformity of metal coating quality across the work piece surface is achieved. Improved constancy of alloy composition may equally well be understood from assuming that the electric potential at the work piece surface is equalized, since alloy composition will in general substantially depend on the electric potential applied to the work piece.

In addition, it has emerged that additive consumption, which otherwise might be due to oxidation by oxygen being formed at inert anodes, has found out to be reduced considerably. Further, accumulation of any degradation products has found out to be subordinate. This makes the use of sensitive additive substances possible. Thus, treatment of the electroplating liquid using active carbon powder to remove such degradation products will no longer be necessary.

Furthermore, using a fill made of packing material makes adaptation to any geometrical arrangement possible. Depending on the shape of the work piece the fill may be shaped correspondingly, so that the shape of the diaphragm can be matched to the shape of the work piece to be plated. Thus, the diaphragm used according to the present invention is much more versatile than screens used hereto before to prevent access of the additive substances to the anode (e.g., as in EP 1 717 351 A1) and to improve evenness of metal coating quality, thickness and of alloy composition.

Another advantage of the diaphragm used according to the invention is that the fill may easily be removed from the device in order to clean the pieces of the fill. Such cleaning operation may be very important since impurities contained in the electroplating liquid pollute the diaphragm thus clogging same.

### Detailed Description of the Invention

As defined herein the term "fill" means a structure composed of a plurality of individual pieces which are lying side by side. The pieces may be randomly arranged in the fill or may be arranged to form a periodic pattern like a cubic or hexagonal close packing.

As defined herein the term "locating the diaphragm in the device such that electric field lines extending between the at least one anode and the work piece placed in the device at least partially traverse the diaphragm" means that either the entire diaphragm is located in a region between the anode and the work piece or only part thereof is located in the region between the anode and the work piece. The region between the anode and the work piece is traversed by electric field lines. If the entire diaphragm is located between the anode and the work piece, the fill made of packing material will entirely be placed in a plane which is located between the anode and the work piece. If only part of the diaphragm is located between the anode and the work piece, not the entire fill of packing material will be placed between the anode and the work piece but part thereof will also be placed outside a plane disposed between the anode and the work piece. Part of the fill of packing material may in this latter case be placed behind the anode or behind the work piece. The anode or the work piece, respectively, may in this case be located within the fill.

As defined herein the term "anode" means a counter electrode, which is arranged in the circuit comprising the workpiece, a current source and said counter electrode. In DC mode electroplating is performed by permanently polarizing the work piece as a cathode and permanently polarizing the anode as an anode. In the reverse pulse electroplating mode alternating positive and negative pulses are applied to the anode and negative and positive pulses, respectively, to the work piece: In this mode, during anodic polarization of the anode, electroplating pulses are applied to the work piece (during these time intervals the work piece is polarized as a cathode), and during cathodic polarization of the anode, deplating pulses are applied to the work piece (during these time intervals the work piece is polarized as an anode). Instead of DC electroplating or reverse pulse electroplating, unipolar pulse electroplating may likewise be performed. In this electroplating mode cathodic electroplating pulses and pulse breaks (zero current pulses) are alternatingly applied to the work piece (and, correspondingly, anodic pulses and pulse breaks are alternatingly applied to the anode).

The diaphragm is preferably made of a casing and the fill made of packing material which is contained in the casing. Such casing may be easily filled with the packing material and will outstandingly serve as a diaphragm in the electroplating of flat work pieces such as printed circuit board material. Preferably in this latter case but not only in this latter case, the device of the invention may furthermore comprise a casing which is made from two (preferably rectangular) front walls arranged parallel to each other and by a plurality of side walls, *i.e.,* two, three, four or even more side walls, preferably three side walls, which join the front walls together.

It will be understood that, considering large pieces of the fill of, for example, 2 cm diameter, homogeneity may be the better the smaller the pieces of the fill of the diaphragm are, because decreasing the size of the pieces down to 1 mm for example will reduce interstice size such that evenness of the electric field between the diaphragm and the work piece may considerably be improved, compared to when the pieces have a larger diameter. However, it will be easily understood that very small pieces may tend to stick to one another thus creating uneven and undesirable interstices between them. Thus, equalization may be worse in this case. Therefore, pieces having a diameter of below 100 µm for example may be disadvantageous for this reason. However, the range indicated may depend to some extent on the material the pieces are made of, because if the pieces are sufficiently slippery such sticking together will not take place easily. On the contrary, if the pieces are made of a material which tends to stick them together, large interstices may eventually be created between the individual pieces (particles) thus compromising equalization. It might therefore be advantageous to employ pieces which have a diameter of more than 100 µm if a less slippery material is used, whereas it might be advantageous to use pieces having an even smaller diameter, down to 20 µm for example, if the pieces do not tend to stick to one another. Irrespective of the material of the fill, pieces having a size (diameter) of from about 0.05 to about 5 mm, more preferably pieces having a size of from about 0.25 to about 2 mm, are preferably used.

The packing material of the fill will preferably be a dielectric material, more preferably glass.

The fill is preferably formed by balls. Balls may easily be filled into the casing of the diaphragm without leaving any large interstices between the balls. Thus the fill will be very homogeneous and will therefore equalize electric field line density across the electroplating volume between the work piece and the anode.

It is more preferable to provide glass balls to fill the diaphragm casing. These balls do not stick to each other. Furthermore, the manufacture thereof is easy. Such balls having a diameter of about 1 mm are for example used in ballpens.

Hence, an optimum size (diameter) of the balls may be from about 0.05 to about 5 mm, more specifically from about 0.25 to about 2 mm.

The casing may be made of a frame, which may be made of a plastics material and which may be covered with gauze made of plastics material for example. The type of plastics material to be used in electroplating operations is well-known to those skilled in the art. Suitable plastics material may be polypropylene or polyvinylchloride.

In a preferred embodiment of the invention the diaphragm may be placed between the at least one anode and the work piece. In an alternative embodiment of the invention the at least one anode may be placed inside the casing. The first embodiment may be preferred because the diaphragm being placed between the anode and the work piece may be thicker than the diaphragm used in the second embodiment. Realizing the first embodiment comprises placing the diaphragm directly in contact with the anode, such that the two items touch each other, or placing the diaphragm spaced to the anode, leaving a space between the anode and the diaphragm of from about 0.5 cm to about 5 cm for example.

The at least one anode used may preferably be inert against the plating liquid and may thus be insoluble. As defined herein, the term "inert anode" means an anode which does not dissolve due to the electroplating operation. Thus, inert anodes do not participate in the electroplating process as one component to be consumed or generated. Hence, an inert anode is substantially dimensionally stable because its shape does not change due to the electroplating operation. This is in contrast to soluble anodes. The latter anodes dissolve due to the electroplating operation. For example an anode made of copper in an electroplating liquid for plating copper is a soluble anode. Due to the electroplating operation the copper anode dissolves to generate copper ions.

Inert anodes are preferred over soluble anodes since they are dimensionally stable. Thus, they provide a consistent geometrical arrangement and accordingly a consistent electric field line distribution between the anode and the work piece.

Therefore, inert anodes markedly contribute to further levelling of the metal coating on the work piece surface with regard to thickness.

In a further preferred embodiment the at least one anode comprises at least one carrier material and at least one active material. Thus the anode may be produced from a suitable material sufficiently resistant to the electroplating liquid on the one side and exhibiting a very low overvoltage to the electrochemical processes occurring at the anode on the other side. The at least one carrier material may preferably be coated with the at least one active material. In a preferred embodiment of the invention at least one carrier material may be made from a so-called valve metal and may preferably selected from the group comprising Ti, Nb, Fe, Ni, Co and alloys of these materials among each other or with other elements. The carrier may be for example made of steel, more specifically of stainless steel. In a more preferred embodiment the carrier may be made of titanium. In order to have a large surface area of the anode the carrier may be made of expanded metal. At least one active metal is selected from the group comprising Pt, Ir, Rh, Pd, Ru or mixed oxides of the at least one active metal. Thus, a carrier comprising an inert metal like Ti, Nb, Fe, Ni, Co, alloys of these metals among each other or with other elements may be coated with an active metal like Pt, Ir, Rh, Ru or a mixed oxide of these metals.

In a more preferred embodiment the metal to be deposited is copper and the plating liquid is a copper plating liquid containing copper ions. If an inert anode is used, a copper ions containing material may be replenished to the copper plating liquid to keep the concentration of copper ions in the liquid constant, since electroplating operation will deplete the solution from copper ions. Such copper ions containing material may for example be copper(II) oxide. Instead of copper(II) oxide as a material replenishing copper ions to the electroplating liquid, other copper ions containing material may be used such as a copper(II) salt. Alternatively, metal pieces, more preferably copper pieces, may be used as a replenishing material. These pieces dissolve in the electroplating liquid if a suitable electrochemical potential is applied to the pieces such as for example by using an external electric current source. Alternatively, such electrochemical potential may also be applied to the copper pieces by including into the electroplating liquid a chemical substance producing such electrochemical potential at the copper metal pieces. For example such chemical substance may be oxygen which is dissolved in the liquid, since oxygen may form OH- species in an aqueous solution while oxidizing copper to copper(II) ions. lron(III) ions are even more suitable as oxidizing species to produce copper(II) ions from copper pieces, while being reduced to iron(II) ions. Iron(III) and iron(II) ion species may for example be the sulfate salts thereof (DD 215 589 A1, DE 43 44 387 A1 being herein incorporated by reference).

### Brief Description of the Drawings

The above and other objects, features and advantages of the invention will become apparent from a consideration of the following detailed description presented in connection with the accompanying drawings in which:
- Fig. 1: is a schematic drawing of an experimental arrangement of a test printed circuit board panel having two inert anodes and two diaphragms according to the invention;
- Fig. 2: is a photograph of a test panel which was used in Examples 1, 2;
- Fig. 3: is diagram of thickness of plated copper on the test panel shown in Fig. 2 (Examples 1, 2);
- Fig. 4: is a schematic drawing of an experimental arrangement of an epoxy laminate panel and anode with the epoxy laminate panel being tilted to a plane parallel to the anode;
- Fig. 5: is a schematic drawing of measuring points on a panel used for thickness and alloy composition measurements (Examples 3 through 6);
- Fig. 6: is a graph showing thickness variation of a tin/lead alloy coating on a test panel (1.5 A/dm² cathodic current density; Examples 3 and 5);

- Fig. 7: is a graph showing thickness variation of a tin/lead alloy coating on a test panel (0.7 A/dm² cathodic current density; Examples 4 and 6);
- Fig. 8: is a graph showing the variation of tin/lead alloy composition on a test panel (1.5 A/dm² cathodic current density; Examples 3 and 5);
- Fig. 9: is a graph showing the variation of tin/lead alloy composition on a test panel (0.7 A/dm² cathodic current density; Examples 4 and 6);
- Fig. 10: is a graph showing brightener consumption (Examples 9 through 11).

### Detailed Description of Preferred Embodiments of the Invention

In order to illustrate preferred embodiments of the invention the effect of a diaphragm on thickness variation across the surface of a work piece, alloy composition variation across the surface of a work piece and reduction of brightener consumption will be shown.

The following are examples that illustrate preferred embodiments of the invention but are intended as being representative only.

### Examples

### Comparative Example 1:

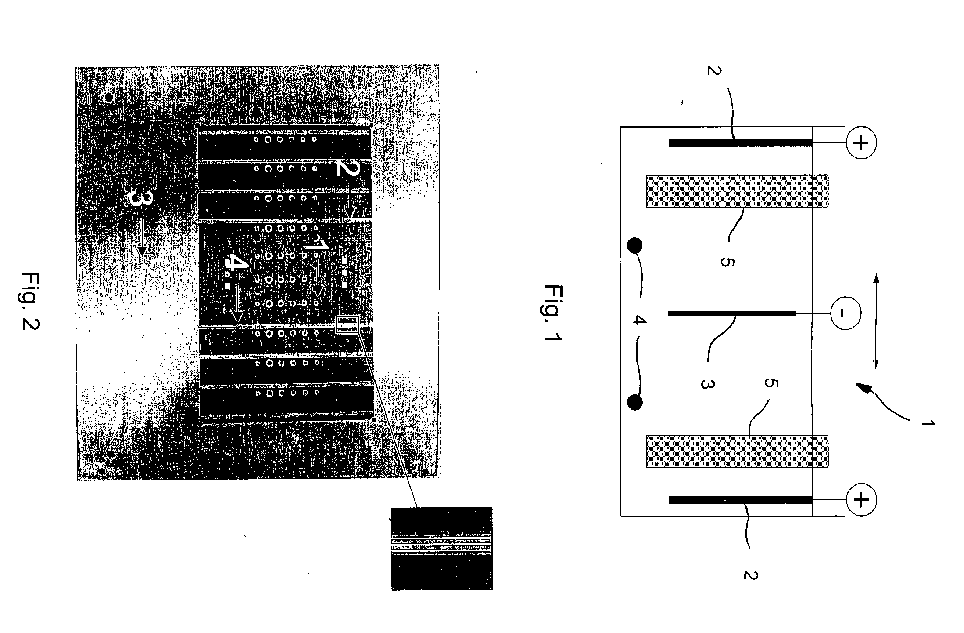

A tank having 20 I volume was filled with a copper plating solution containing CuSO₄ (with Cu²⁺ concentration being 24 g/l), concentrated H₂SO₄ (with the concentration thereof being 245 g/l), NaCl (with Cl⁻ concentration being 60 mg/l), a proprietary levelling component (Cupracid® TP, tradename and product of Atotech Deutschland; concentration: 20 ml/l) and a proprietary brightener (Cupracid® TP; concentration: 1 ml/l). Two inert anodes (titanium expanded metal having a TaO₂/IrO₂ mixed oxide coating) were placed into the tank, each one facing one end wall of the tank. A test printed circuit board panel being suspended from a carrier was immersed into the copper plating solution in the tank, just at the center between and parallel to the two inert anodes. Fresh and purified air was introduced into the solution from nozzles placed at the bottom of the tank and located between the test panel and the anodes in order to agitate the solution. A schematic drawing of the arrangement is shown in Fig. 1, with the proviso that in this first comparative experiment no diaphragms are used. The individual elements shown are indexed with numerals, these numerals being: 1- tank, 2- inert anodes, 3- test panel, 4- air nozzles. The test panel was moved back and forth parallel to the tank bottom (arrow). The layout of the test panel is shown in Fig. 2.

For effecting electroplating of the panel the inert anodes and the panel were electrically connected to a current source. In a first comparative experiment the cathodic current density was set to 2 A/dm². Plating was conducted for 57 min. Thus, theoretically 25 µm of copper were electroplated to the board surface. After this first plating experiment thickness on various places on the test panel was measured using XRF (atomic X-ray fluorescence). The results are shown in Table 1.

### Example of the Invention 2:

The setup of Comparative Example 1 was used, with the exception that diaphragms 5 were placed into the tank 1 just between the test panel 3 and the inert anodes 2 as shown in Fig. 1. The diaphragms were produced of casings made from a polypropylene grid forming a rectangular box with a width of about 2 cm and a height and depth which were slightly larger than those of the inert anodes. The grid faces were covered from the inside of the box with gauze made of polypropylene. A fill of glass balls having a diameter of 2 mm each was poured into the cavity formed in the hollow interior of the diaphragm. Two of such diaphragms were then placed into the tank in direct vicinity of the inert anodes with a spacing of about 1 cm between the diaphragms and the anodes.

The same plating conditions were applied as before. The results of this experiment are shown in Table 1.

**Table 1 (Variation of copper thickness on the test panel):**

| Sample | Without Diaphragm | With Diaphragm |
|---|---|---|
| 1 - Through Hole | 15.5 µm | 20.2 µm |
| 2 - Lines | 25.4 µm | 24.8 µm |
| 3 - Ground Area | 20.9 µm | 25.8 µm |
| 4 - Lines | 29.6 µm | 27.9 µm |

From the above experiments it will be apparent that equalization of copper thickness, which is desired, takes place if a diaphragm is used. Especially at those places on the test panel which are prominently prone to higher or lower copper thickness, like the through hole walls and the lines with index 4, thickness is conformed considerably to the mean thickness of 25 µm.

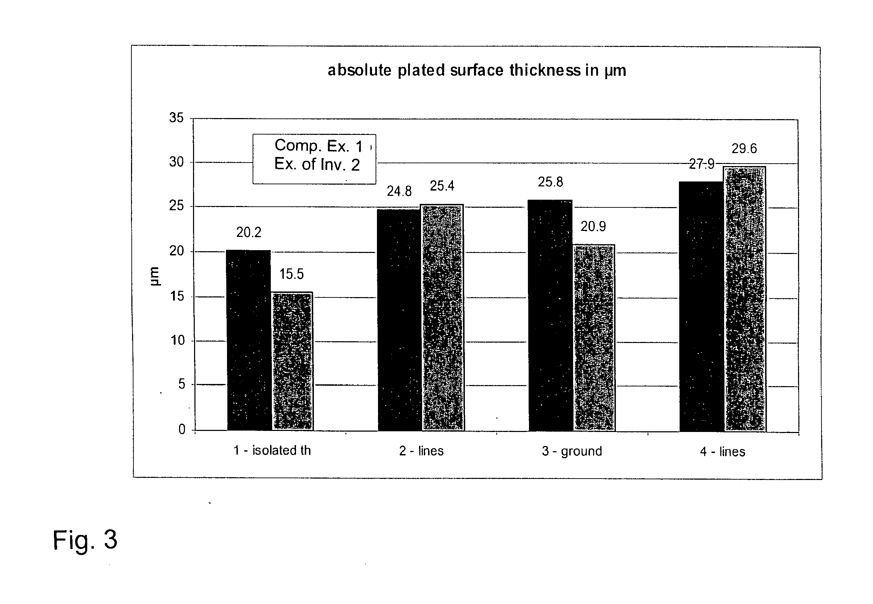

The results are also shown in a diagram displayed in Fig. 3.

### Comparative Examples 3 and 4:

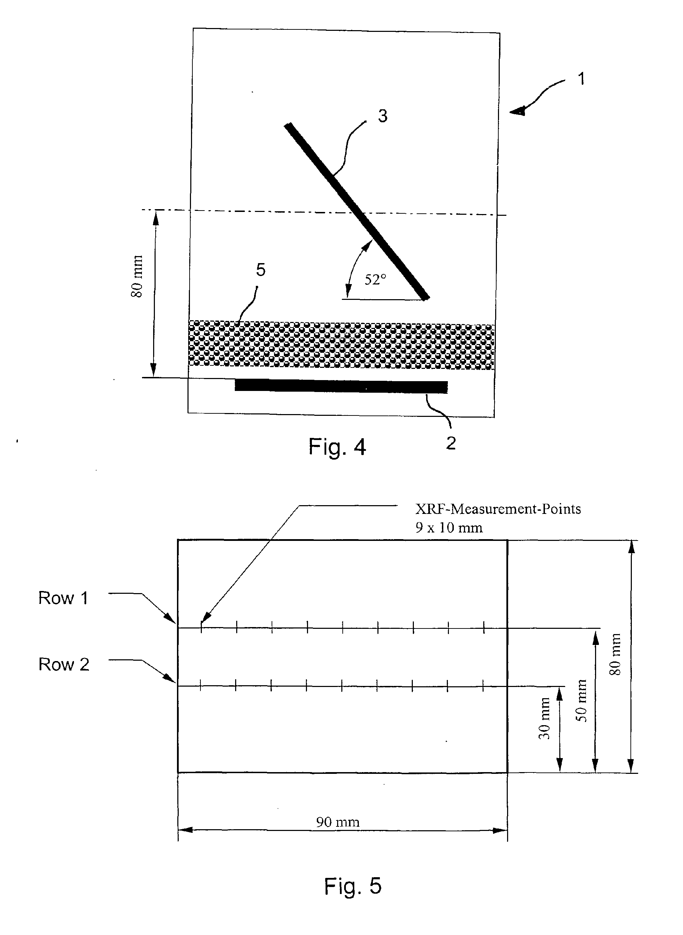

In further experiments a tin/lead alloy was plated to an epoxy laminate panel which was copper clad on one side and had a 8 cm by 9 cm size. The epoxy laminate panel was placed into a plating tank which also accommodated an anode. The anode was made of a tin/lead alloy, having a tin content of 60 wt.-% and a lead content of 40 wt.-%. The epoxy laminate panel was tilted to the plane of the anode, the angle between this plane and the panel being 52°. The spacing between a center line at the panel and the anode was set to 8 cm. The arrangement of this tank with epoxy laminate plate and anode is schematically shown in Fig. 4, with the proviso that in this further comparative experiment no diaphragms are used. The individual elements shown are indexed with numerals, these numerals being: 1- tank, 2- anode, 3- epoxy laminate panel.

The electroplating liquid contained: a tin salt (with the Sn concentration being 18 g/l), acid (the concentration thereof being 110 g/l), a lead salt (with the lead concentration being 13 mg/l), a proprietary first additive (Sulfotech Part A, product of Atotech Deutschland, concentration: 40 ml/l) and a proprietary second additive (Sulfotech Part B, concentration: 20 ml/l).

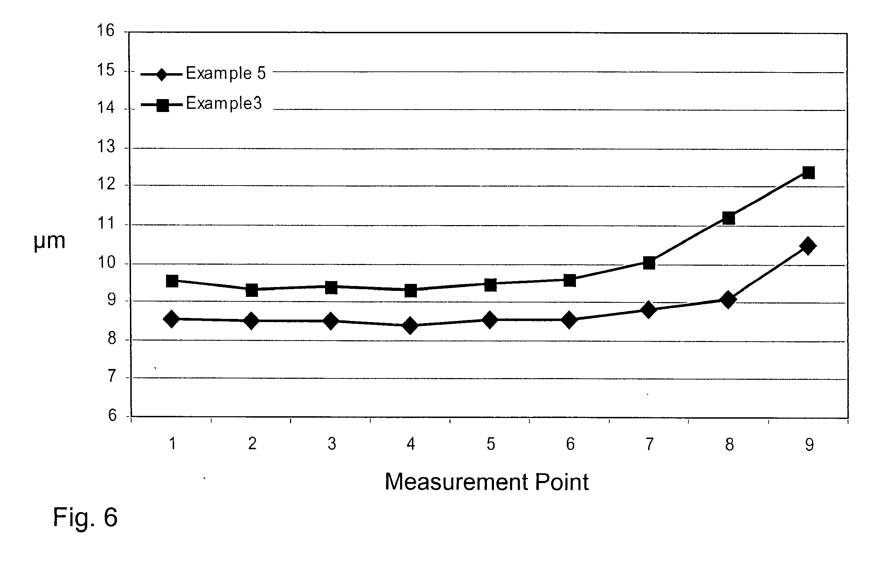

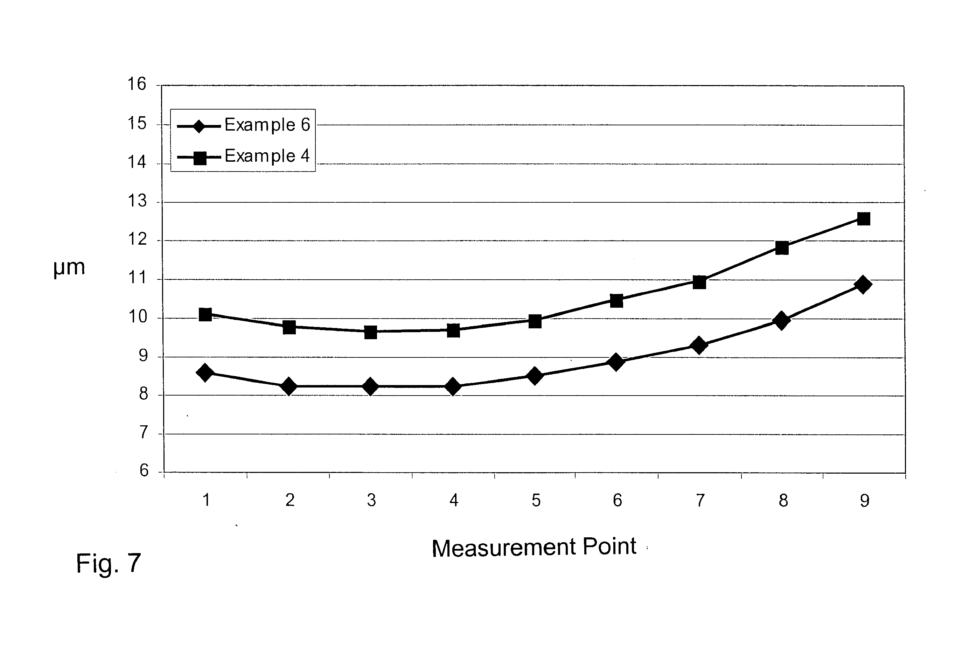

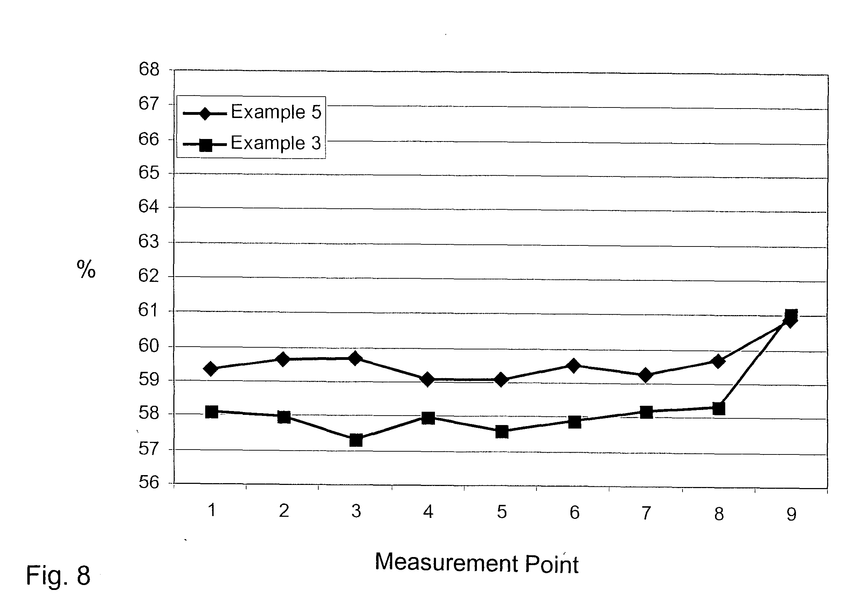

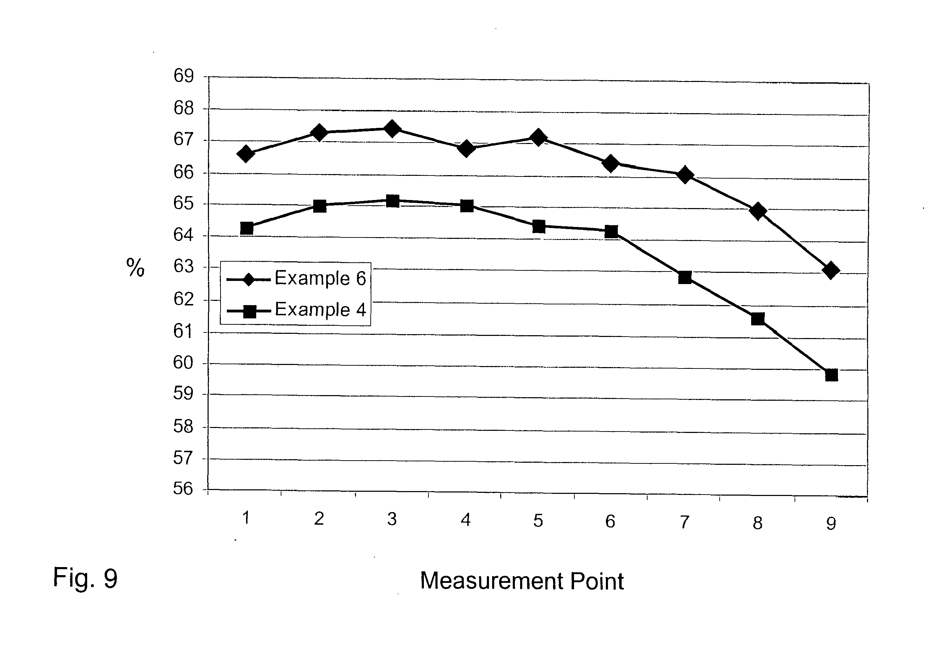

For effecting electroplating of the panel the anode and the panel were electrically connected to a current source. In these comparative experiments the cathodic current density was set to 1.5 A/dm² (Example 3) or 0.7 A/dm² (Example 4), respectively. Plating was conducted for 11 min (Example 3) or 20 min (Example 4), respectively. Thus, theoretically 10 µm of a tin/lead alloy were plated to the panel surface. After these plating experiments thickness and alloy composition on various places on the test panel (*cf.* Fig. 5) were measured using XRF. Mean values taken at rows 1 and 2 on the panel were used. The results are shown in Figs. 6 through 9. Numerical values are given in Table 2.

### Examples of the Invention 5 and 6:

The setup of Comparative Examples 3 and 4 was used, with the exception that a diaphragm 5 was placed into the tank 1 just between the test panel 3 and the anode 2 as shown in Fig. 4. The configuration of the diaphragm was the same as in Example 2. The electroplating liquid composition was that of Comparative Examples 3 and 4.

The same plating conditions were applied as before (Example 5: 1.5 A/dm² current density, 11 min plating time; Example 6: 0.7 A/dm² current density, 20 min plating time). Mean values taken at rows 1 and 2 on the panel were used. The results of this experiment are shown in Figs. 6 through 9. Numerical values are given in Table 2.

**Table 2 (Variation of tin/lead alloy thickness and composition on the epoxy laminate panel):**

| | | Plated Surface Thickness | | | Tin-Content | | |
|---|---|---|---|---|---|---|---|
| Current density | | Min [µm] | Max [µm] | SD [µm]¹) | Min [µm] | Max [µm] | SD [µm]¹) |
| 1.5 A | w/o ²) | 8.4 | 10.5 | 0.7 | 59.1 | 60.9 | 0.5 |
| 1.5 A | w³) | 9.3 | 12.4 | 1.1 | 57.4 | 61.1 | 1.1 |
| 0.7 A | w/o ²) | 8.2 | 10.9 | 0.9 | 63.1 | 67.5 | 1.4 |
| 0.7 A | w³) | 9.7 | 12.6 | 1.0 | 59.9 | 65.2 | 1.8 |

| | | | | | | | |
|---|---|---|---|---|---|---|---|
| ¹) SD: Standard Deviation ²) w/o: without diaphragm (Comparative Examples 3, 4) ³) w: with diaphragm (Examples of the Invention 5, 6) | | | | | | | |

From the above experiments it will be apparent that equalization of tin/lead alloy thickness and composition takes place if a diaphragm is used.

### Comparative Example 7:

In a further experiment the potential at a test panel was measured. For this Comparative Example the setup of Comparative Example 1 was used. The electroplating liquid composition was the same as that of Comparative Example 1. A potential probe (Ag/AgCl reference electrode) was placed in direct vicinity to the test panel during the electroplating operation. One pole of the probe was electrically contacted to the inert anode. The potential was measured together with the voltage applied across the inert anode - test panel circuit. Table 3 illustrates the results of these measurements.

### Example of the Invention 8:

The setup employed in Comparative Example 7 was used to probe the potential at the test panel, except that a diaphragm was placed between the inert anode and the test panel (setup of Example of the Invention 2). The results of the potential measurements together with the voltage applied across the inert anode - test panel circuit are shown in Table 3.

**Table 3 (Potentials and Voltages)**

| | Without Diaphragm | With Diaphragm |
|---|---|---|
| Voltage (rectifier) | 0.5 V | 0.6 V |
| Electropotential | 215 mV | 252 mV |

These experiments show that the electropotential between the inert anode and the test panel was increased by 17 % when the diaphragm was used.

### Comparative Example 9:

The setup employed in Comparative Example 1 was used in this experiment to determine brightener consumption. Further as a test of anode influence of brightener consumption the potential at the anode surface was measured. For this purpose a Ag/AgCl reference electrode was placed directly before the inert anode surface.

A copper plating solution was used for this experiment, the composition thereof being: CuSO₄ (with Cu²⁺ concentration being 44 g/l), concentrated H₂SO₄ (with the concentration thereof being 130 g/l), NaCl (with Cl⁻ concentration being 40 mg/l), a proprietary levelling component (Inplate® D12, tradename and product of Atotech Deutschland; concentration: 15 ml/l) and a proprietary brightener (Inplate® D12, product of Atotech Deutschland, concentration: 15 ml/l). Cathodic current density was set to 1.5 A/dm². Bath loading (surface area per volume of the electroplating solution) was set to A_{TOT}/V = 1 dm²/l (A_{TOT}: total surface area; V: volume)). Concentration of the brightener was determined analytically after 1 h of electroplating. It turned out that the concentration had decreased from initially 15 ml/l to 0.834 ml/l. The consumption of the brightener thus was calculated to be 142 l/10 kAh. The potential at the anode surface was measured to be 1.378 V.

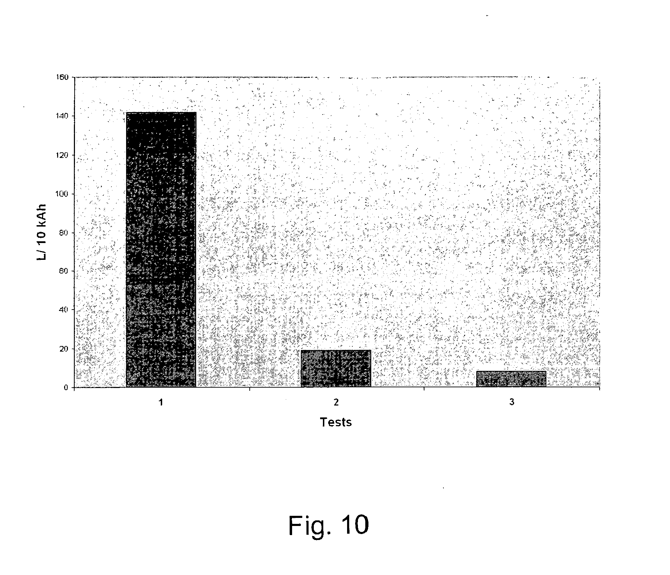

The results for brightener consumption are shown in Fig. 10 and Table 4 and the results for potential measurements at the anode surface are shown in Table 5.

### Examples of the Invention 10 and 11:

The setup employed in Comparative Example 9 was used to determine the brightener consumption and potential at the diaphragm surface (instead of at the inert anode surface), except that a diaphragm was placed between the inert anode and the test panel (setup of Example of the Invention 2).

The results for brightener consumption are shown in Fig. 10 and Table 4 and the results for potential measurements at the anode surface are shown in Table 5.

**Table 4 (Brightener Consumption)**

| Test | cₜ₌₀ [ml/l] | cₜ₌₁ₕ [ml/l] | Current Density [A/dm²] | Bath Loading A_{TOT}/V | Consumption [I/10 kAh] |
|---|---|---|---|---|---|
| 1 (Ex. 9) | 15 | 0.834 | 1.5 | 1 dm²/l | 142 |
| 2 (Ex. 10) | 15 | 13.1 | 1.5 | 1 dm²/l | 19 |
| 3 (Ex. 11) | 15 | 14.2 | 1.5 | 1 dm²/l | 8 |

**Table 5 (Potential at the Inert Anode)**

| Test | Current Density [A/dm²] | Bath Loading A_{TOT}/V | Potential at the Anode V |
|---|---|---|---|
| 1 (Ex. 9) | 1.5 | 1 dm²/l | 1.378 |
| 2 (Ex. 10) | 1.5 | 1 dm²/l | 1.512 |
| 3 (Ex. 11) | 1.5 | 1 dm²/l | 1.650 |

These results show that brightener consumption is considerably reduced from 142 l/10 kAh to 19 l/kAh and 8 l/kAh, respectively, if a diaphragm is employed. This effect is further enhanced if the diaphragm is placed in front of the inert anode instead of placing the inert anode inside the glass ball bed of the diaphragm.

### Example of the Invention 12:

The setup employed in the Example of the Invention 1 was used to test the ability to fill buried holes having 100 µm, 125 µm or 150 µm diameter and about 80 µm depth in a printed circuit board with copper. Conditions were as follows: Cathodic current density: 1.5 A/dm², plating time: 75 min, air agitation: 1.9 Nm³/h, Bath loading A_{TOT}/V = 1 dm²/l. It emerged that the filling with copper was excellent with no void being produced at the site of the hole.

### Example of the Invention 13:

The setup of the Example of the Invention 12 was used to monitor filling performance of the electroplating solution employed under the conditions of the same Example. A series of panels was treated successively over a time period of 20 hours. During this time the additives (proprietary leveller and brightener Cupracid®) as well as copper ions were replenished. Replenishment of the copper ions was made by adding CuO to the tank. This material dissolved in the electroplating solution, thus liberating copper(II) ions.

The filling capability of the electroplating solution was excellent throughout the entire experiment.

## Claims

1. Device for the electrolytic plating of a metal on a work piece, the device comprising at least one anode and a diaphragm, the diaphragm being located in the device such that electric field lines extending between the at least one anode and the work piece placed in the device at least partially traverse the diaphragm, **characterized in that** the diaphragm comprises a fill made of packing material.

2. Device according to claim 1, **characterized in that** the diaphragm comprises a casing with the fill of packing material being contained in the casing.

3. Device according to any one of the preceding claims, **characterized in that** the casing is made from two front walls arranged parallel to each other and by a plurality of side walls which join the front walls together.

4. Device according to any one of the preceding claims, **characterized in that** the fill is made of balls.

5. Device according to any one of the preceding claims, **characterized in that** the fill is made of glass balls.

6. Device according to any one of the preceding claims, **characterized in that** the balls have a diameter of from about 0.05 to about 5 mm.

7. Device according to any one of the preceding claims, **characterized in that** the diaphragm is placed between the at least one anode and a location where the work piece is arranged when being metal plated.

8. Device according to any one of claims 2 to 6, **characterized in that** the at least one anode is placed inside the casing.

9. Device according to any one of the preceding claims, **characterized in that** the at least one anode is inert against the plating liquid.

10. Device according to any one of the preceding claims, **characterized in that** the at least one anode comprises at least one carrier material and at least one active material.

11. Device according to claim 10, **characterized in that** the at least one carrier material is coated with the at least one active material.

12. Device according to any one of claims 10 and 11, **characterized in that** at least one carrier material is selected from the group comprising Ti, Nb, Fe, Ni, Co and alloys of these materials among each other or with other elements.

13. Device according to any one of claims 10 to 12, **characterized in that** at least one active metal is selected from the group comprising Pt, Ir, Rh, Pd, Ru or mixed oxides of the at least one active metal.

14. Device according to any one of the preceding claims, **characterized in that** the at least one anode is made of expanded metal.

15. Method of electrolytic plating of a metal on a work piece, comprising providing at least one anode and the work piece, bringing the at least one anode and the work piece into contact with a plating liquid and locating a diaphragm with respect to the at least one anode and the work piece such that electric field lines extending between the at least one anode and the work piece at least partially traverse the diaphragm,
**characterized in that** the diaphragm comprises a fill made of packing material.

16. Method according to claim 15, **characterized in that** the diaphragm comprises a casing with the fill of packing material being contained in the casing.

17. Method according to any one of claims 15 and 16, **characterized in that** the fill is made of balls.

18. Method according to any one of claims 15 to 17, **characterized in that** the fill is made of glass balls.

19. Method according to any one of claims 15 to 18, **characterized in that** the at least one anode is inert against the plating liquid.

20. Method according to claim 19, **characterized in that** the metal is copper, that the plating liquid is a copper plating liquid containing copper ions and that a copper ions containing material is replenished to the plating liquid to maintain the concentration of copper ions in the copper plating liquid.

21. Method according to claim 20, **characterized in that** the copper ions containing material is copper(II) oxide.
